# EUROPEAN PATENT APPLICATION

(11) **EP 4 848 917 A1**
(43) Date of publication of application: **02.12.2026**
(21) Application number: 25745058.5
(22) Date of filing: 21.01.2025
(51) Int. Cl.: H05K 7/20, H01L 23/28, H01L 23/29, H01L 23/31, H02M 3/28, H05K 5/00

(54) **ELECTRONIC DEVICE**

(30) Priority: 24.01.2024 JP 2024008923
(71) Applicant: Shindengen Electric Manufacturing Co., Ltd., Tokyo 100-0004 (JP)
(72) Inventor: SATO, Haruto, Asaka-shi, Saitama 351-8503 (JP); YANAGITA, Satoshi, Asaka-shi, Saitama 351-8503 (JP)
(74) Representative: Wynne-Jones IP Limited
(86) International application number: PCT/JP2025/001726
(87) International publication number: WO 2025/159074

(57) **Abstract**

Provided is an electronic device that makes it possible for multiple kinds of heat-generating electronic components to dissipate heat and that can be miniaturized while suppressing increase in manufacturing costs and weight. An electronic device 1 comprises: a housing 10; a partitioning part 40 that partitions an accommodation space inside the housing 10; and a switching element 24 that is fixed to the partitioning part 40 and uses the partitioning part 40 as a heat dissipation path. The interior of a resin sealing section 42 partitioned off by the partitioning part 40 is resin-sealed.

## Description

### Technical Field

The present invention relates to an electronic device.

### Background Art

Proposals have been made to attach an electronic component that generates heat to a vertical wall that stands upright from a bottom face of a housing, and to dissipate heat from the electronic component toward the housing side via the vertical wall (see, for example, Patent Document 1).

### SUMMARY OF THE INVENTION

### Problem to be Solved by the Invention

As described in Patent Japanese Patent Application Laid-open (JP-A) No. 2000-183574, a method of attaching an electronic component to a vertical wall that stands upright from a bottom face of a housing, by application to relatively small electronic components such as semiconductor devices, enables the mounting area of the electronic component to be reduced, and miniaturization of the device to be achieved. However, application to relatively large electronic components such as transformers is difficult.

As a method of dissipating heat from a relatively large electronic component, there is a method of sealing the electronic component with a resin having high thermal conductivity. However, heat dissipation by this kind of resin sealing usually requires that substantially the entire internal space of the housing be filled with resin, and since some electronic components cannot be resin sealed, problems of increased cost and weight have arisen owing to an increase in the resin amount.

In consideration of the above circumstances, an object of the present invention is to obtain an electronic device that enables heat dissipation from plural types of electronic components that generate heat, while suppressing increases in cost and weight during manufacturing, and that enables miniaturization of the device.

### Means for Solving the Problem

An electronic device according to a first aspect of the present invention includes a housing; a partition portion partitioning a housing space inside the housing; and an electronic component fixed to the partition portion and using the partition portion as a heat dissipation path, in which an interior of a partitioned compartment is resin-sealed.

### Effect of Invention

According to the electronic device according to the first aspect of the present invention, a housing space inside the housing is partitioned by the partition portion, and the interior of a partitioned compartment is sealed with resin. This enables heat to be dissipated from relatively large electronic components inside the compartment, while suppressing the amount of resin filled in the housing. Further, an electronic component is fixed to the partition portion, and the partition portion is used as a heat dissipation path of the electronic component. This enables the required area of the bottom face of the housing to be reduced, by utilizing the partition portion as the mounting face of a relatively small electronic component and as a heat dissipation portion. This enables cost increases and weight increases during manufacturing to be suppressed, and it is possible to obtain an electronic device that is capable of dissipating heat from plural types of electronic components that generate heat, and that is capable of achieving miniaturization of the device.

### BRIEF DESCRIPTION OF THE DRAWINGS

Fig. 1 is a block diagram illustrating a circuit configuration of an electronic device according to the present exemplary embodiment.
Fig. 2 is a plan view of the inside of a housing of an electronic device according to the present exemplary embodiment, viewed from an upper side of the device.
Fig. 3 is a partially enlarged plan view illustrating the region P illustrated in Fig. 2 in an enlarged manner.
Fig. 4 is a cross-section of a housing showing a state sectioned along the line IV-IV in Fig. 2.
Fig. 5 is a schematic diagram illustrating a first modified example of a partition portion according to the present exemplary embodiment.
Fig. 6 is a schematic diagram illustrating a second modified example of a partition portion according to the present exemplary embodiment.
Fig. 7 is a schematic diagram illustrating a third modified example of a partition portion according to the present exemplary embodiment.

### DESCRIPTION OF EMBODIMENTS

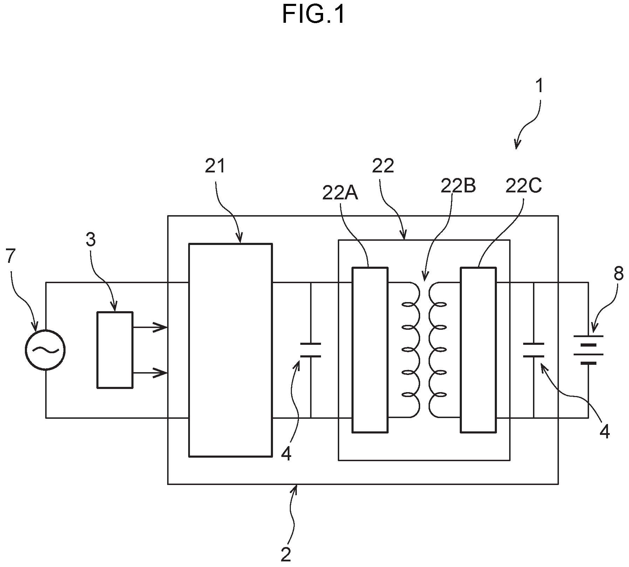

Explanation follows regarding an electronic device 1 according to an exemplary embodiment of the present invention, with reference to Figs. 1 to 4. In the present exemplary embodiment, for convenience of explanation, directions indicated by up and down, left and right, and front and rear arrow in each of the drawings as appropriate are defined as an up-down direction, a left-right direction, and a front-rear direction of the electronic device 1, respectively.

Note that unless specifically stated otherwise in the specification, the respective elements are not limited to a single element, and plural elements may be present. Further, throughout the drawings, the same reference numerals are appended to substantially the same elements, and duplicate explanation thereof is omitted from the specification.

### (Overall Configuration of Electronic Device)

In the present exemplary embodiment, explanation is provided regarding an electronic device 1, as an example of an electronic device according to the present invention, which is for converting AC voltage supplied from an AC power supply 7 into DC voltage and charging a battery 8 installed in an electric vehicle (EV) or a plug-in hybrid vehicle (PHV) (see Fig. 1.) This kind of electronic device 1 is also referred to as an onboard charger.

Fig. 1 is a block diagram illustrating a basic circuit configuration of an electronic device 1. As illustrated in this drawing, the electronic device 1 includes a power conversion circuit portion 2 that converts an AC voltage supplied from an AC power supply 7 into a DC voltage, and a controller 3 that is electrically connected to the power conversion circuit portion 2 and that controls conversion of electric power from AC to DC. The power conversion circuit portion 2 includes a PFC circuit portion 21 and a converter circuit portion 22. As an example, the PFC circuit portion 21 is composed of a one-stage type PFC (Power Factor Correction) circuit including a single converter, and improves the power factor of the power supply by converting AC power into DC power and shaping the output waveform. The converter circuit portion 22 configures a known DC-DC converter, and converts DC power output from the PFC circuit portion 21 to the required level for charging the battery 8. As an example, the converter circuit portion 22 includes a transformer 22B, a converter input portion 22A disposed at an input side of the transformer 22B, and a converter output portion 22C disposed at an output side of the transformer 22B. DC power output from the PFC circuit portion 21 is boosted or stepped down via the converter input portion 22A and the transformer 22B, and rectified and smoothed by the converter output portion 22C.

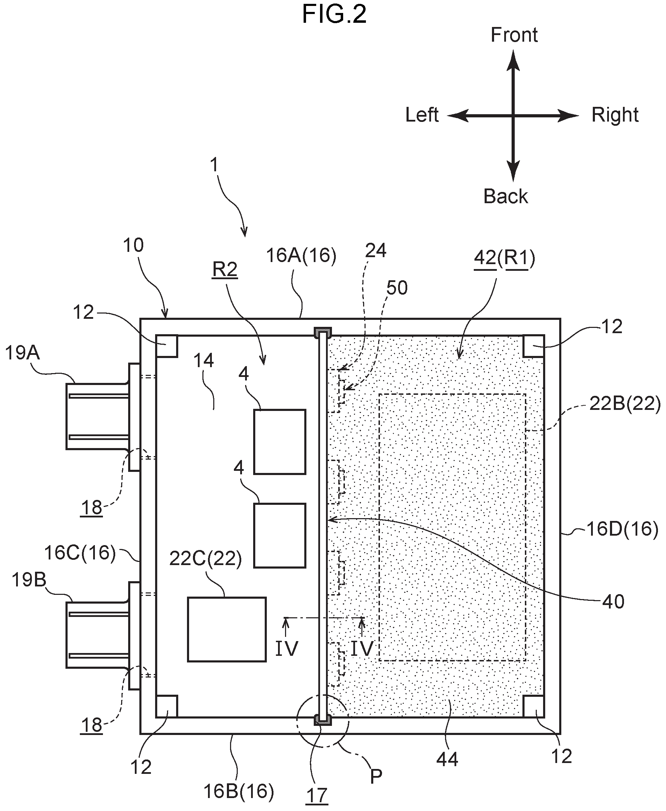

The above-described PFC circuit portion 21 and converter circuit portion 22 include plural switching elements 24 (see Fig. 2) configured by MOSFETs, IGBTs, or the like. These switching elements 24, the transformer 22B configuring the converter circuit portion 22, and the like, are heat generating components that generate heat during operation, and it is desirable to provide heat dissipation means. Note that the switching element 24 is an example of a relatively small electronic component in the present invention, and the transformer 22B is an example of a relatively large electronic component in the present invention.

In the electronic device 1, in a housing 10 in which the power conversion circuit portion 2 is housed, heat dissipation means are provided via a partition portion 40 that partitions the housing space inside the housing 10. Detailed explanation follows regarding the internal configuration of the housing 10 of the electronic device 1.

### (Housing)

Fig. 2 is a plan view of the housing 10 of the electronic device 1 seen from the device upper side. As illustrated in Fig. 2, the housing 10 is formed in a rectangular box shape that is open upward. It is preferable that the housing 10 be formed of a material that has electrical conductivity and high thermal conductivity, and in one example of the present exemplary embodiment, the housing 10 is made of an aluminum die cast.

The housing 10 includes a bottom wall portion 14 configuring a bottom face of the housing space inside the housing 10, and a side wall portion 16 that stands upright from a peripheral portion of the bottom wall portion 14. The side wall portion 16 includes a front wall portion 16A, a rear wall portion 16B, a left wall portion 16C, and a right wall portion 16D, and forms a rectangular frame shape in plan view from above the device. Base portions 12 that support corners of a wiring board 30, described later, are integrally formed with the side wall portions 16 and the bottom wall portion 14 at the four corners of the side wall portions 16.

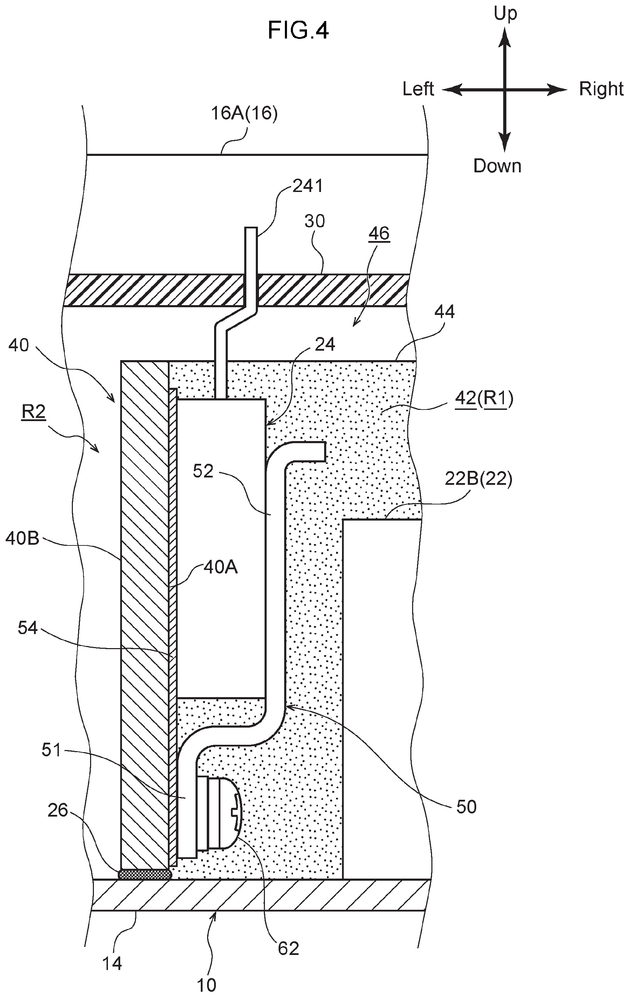

A through hole 18 that penetrates the left wall portion 16C in the plate thickness direction is provided at two places at a left side portion of the housing 10. External connection connectors 19A, 19B are respectively attached to these through holes 18. In the present exemplary embodiment, the external connection connector 19A at the input side is attached to one through hole 18, and the external connection connector 19B at the output side is attached to the other through hole 18. The external connection connectors 19A, 19B are connected to a wiring board 30 (see Fig. 4), housed inside the housing 10 at an upper portion. Note that in Fig. 2, the wiring board 30 is omitted for simplicity of explanation.

### (Partition Portion)

A partition portion 40 made of sheet metal, which is configured separately from the housing 10, is disposed in the housing space inside the housing 10. The partition portion 40 configures a vertical wall that stands upright with respect to the bottom face of the housing 10, and partially partitions the housing space inside the housing 10. As an example, the partition portion 40 is formed in a rectangular plate shape with the front-rear direction serving as a length direction, and the left-right direction serving as a plate thickness direction.

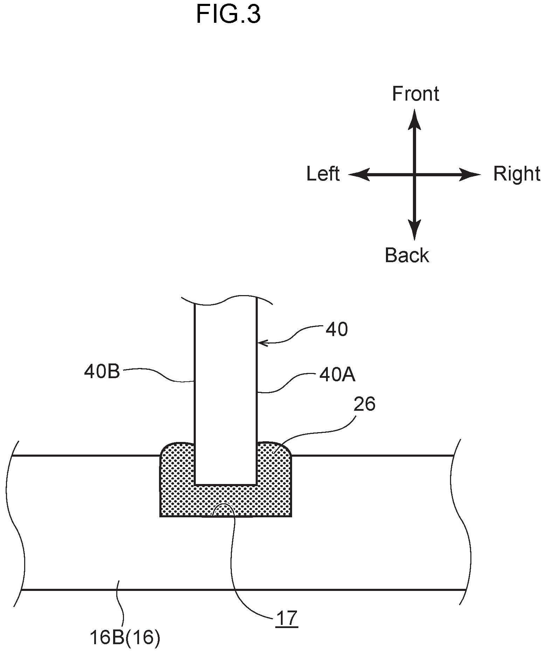

As illustrated in Fig. 3, the one and the other end portions in the length direction of the partition portion 40 are inserted into grooves 17 formed in the side wall portions 16 of the housing 10, such that the partition portion 40 is supported in an upright posture with respect to the bottom wall portion 14. Further, inside the groove 17, a space between the housing 10 and the side wall portion 16 is sealed by a sealing material 26. In the present exemplary embodiment, the housing space inside the housing 10 is partitioned into left and right portions by the partition portion 40. Although it is preferable that the partition portion 40 be formed of a metal material with high thermal conductivity, there is no limitation to this. It may be formed using a resin material with high thermal conductivity.

Note that a configuration in which the grooves 17 are formed in the side wall portions 16 of the housing 10, and the end portions of the partition portion 40 are inserted and supported is not essential. A flange may be formed at an end portion of the partition portion 40, and the partition portion and the housing 10 may be fixed together by screwing or the like through the flange, or the partition portion 40 may configure a portion of a box-shaped module case, as in a first modified example, described later. The sealing material 26 may be an adhesive.

The transformer 22B is housed in a first housing space R1 at the right side inside the housing 10 partitioned by the partition portion 40. Further, electronic components, such as the converter output portion 22C and plural capacitors 4 provided for smoothing, are housed in a second housing space R2 at the left side inside the housing 10 partitioned by the partition portion 40. The right-side housing space is a resin-sealed compartment 42 being a compartment having its interior sealed by a resin. The resin-sealed compartment 42 is resin-sealed by a resin 44 (see Fig. 4) in which a high thermal conductivity filler is mixed.

As illustrated in Figs. 2 and 4, a switching element 24 that uses the partition portion 40 as a heat dissipation path is fixed to the partition portion 40. The switching element 24 is fixed to a first side face 40A of the partition portion 40 facing the inside of the resin-sealed compartment 42, by a presser 50.

The presser 50 is configured by a plate body that is curved into a substantial crank shape in side view, and has a fixing portion 51 provided contacting the first side face 40A, and a pressing portion 52 provided separated from the first side face 40A. The fixing portion 51 is fixed to the first side face 40A using a fastener such as a screw 62. A seat-shaped insulating member 54 is disposed between the fixing portion 51 and the first side face 40A. The pressing portion 52 is configured to hold the switching element 24 by pressing the switching element 24 inserted between the pressing portion 52 and the first side face 40A so as to urge the switching element 24 toward the side of the first side face 40A. In the present exemplary embodiment, an open end of the pressing portion 52 is open toward the upper side of the housing 10. A lead wire 241 of the switching element 24 serving as a connection member (a lead wire 241 extending from the switching element 24 fixed to the partition portion 40) extends upward from the resin-sealed compartment 42.

A leading end of each lead wire 241 extends toward a substrate housing portion 46 provided inside the housing 10, and is connected to the wiring board 30. The substrate housing portion 46 is provided so as to correspond to the partition portion 40, and faces the resin-sealed compartment 42. In the present exemplary embodiment, the substrate housing portion 46 is formed above the partition portion 40 and above the housing space inside the housing 10. In the switching element 24 fixed to the partition portion 40, the leading end of the lead wire 241 projecting from the resin-sealed compartment 42 is connected to the wiring board 30 disposed in the substrate housing portion 46. The wiring board 30 is disposed substantially in parallel with the bottom wall portion 14 of the housing 10 in a posture in which the up-down direction is the plate thickness direction. The four corners of the wiring board 30 are fixed to the base portions 12 that stand upright from the four corners of the bottom wall portion 14 of the housing 10, using fastening members such as screws.

As described above, by forming the resin-sealed compartment 42 at the lower portion of the housing space inside the housing body 10, and configuring the substrate housing portion 46 at the upper portion of the housing space, installation work of the partition portion 40 with respect to the housing 10, filling work of the resin 44, and connection work of the electronic component to the wiring board 30 can be performed sequentially from one direction.

Note that in the above description, a configuration in which the switching element 24 is fixed to the partition portion 40 by the presser 50 is not essential. The switching element 24 may be directly fixed to the partition portion 40 using a fastening member such as a screw or an adhesive. Further, it is not essential that the switching element 24 be fixed to the first side face 40A facing the inside of the resin-sealed compartment 42. It may be fixed to a second side face 40B (see Fig. 4) of the partition portion 40 facing the second housing space R2 that is not sealed by the resin 44.

### (Mechanism and Effects)

In the electronic device 1 according to the present exemplary embodiment, the housing space inside the housing 10 is partitioned by the partition portion 40, and the interior of the compartment (the resin-sealed compartment 42) is resin-sealed. This enables heat dissipation of relatively large electronic components, such as the transformer 22B, to be favorable inside the compartment, while suppressing the amount of resin filled inside the housing 10. Further, relatively small electronic components such as the switching element 24 are fixed to the partition portion 40, and the partition portion 40 is used as a heat dissipation path for the switching element 24. This enables the required area of the bottom face of the housing 10 to be reduced, by utilizing the partition portion 40 as a mounting face of a relatively small electronic component and as a heat dissipation portion. This enables cost increase and weight increase during manufacturing to be suppressed, enables heat dissipation of plural types of electronic components that generate heat, and enables an electronic device that is capable of achieving miniaturization of the device.

Further, in the present exemplary embodiment, the partition portion 40 is configured separately from the housing 10. This enables an electronic component to be fixed to the partition portion 40 outside the housing 10, enabling a structure of the electronic device 1 to be obtained that is excellent in assembly workability.

Further, in the present exemplary embodiment, the switching element 24 fixed to the partition portion 40 is fixed to the first side face 40A at the resin-sealed side of the partition portion 40. Thus, in the switching element 24 fixed to the partition portion 40, both the partition portion 40 and the resin 44 filled in the resin-sealed compartment 42 can be used as a heat dissipation path.

Further, in the present exemplary embodiment, a compartment to be resin-sealed is formed by the partition portion 40 in the housing space of the housing 10, and a substrate housing portion 46 corresponding to the partition portion 40 is formed. Further, a lead wire 241 extending from the switching element 24 fixed to the partition portion 40 is connected to the wiring board 30 disposed in the substrate housing portion 46. Thus, in the housing 10, the lead wire 241 of the switching element 24 is disposed so as to extend from the partition portion 40 toward the substrate housing portion 46. Thus, in the process of housing the wiring board 30 in the substrate housing portion 46 inside the housing 10 after sealing a compartment inside the housing 10 with resin, connection between the switching element 24 fixed to the partition portion 40 and the wiring board 30 can be easily performed.

Explanation has been given above regarding the electronic device 1 according to the present exemplary embodiment; however, the present invention is not limited thereto. Modified examples of the above exemplary embodiment are listed below. Each modified example basically follows the configuration of the electronic device according to the above exemplary embodiment, and thus the same mechanism and effects can be obtained.

### (First Modified Example)

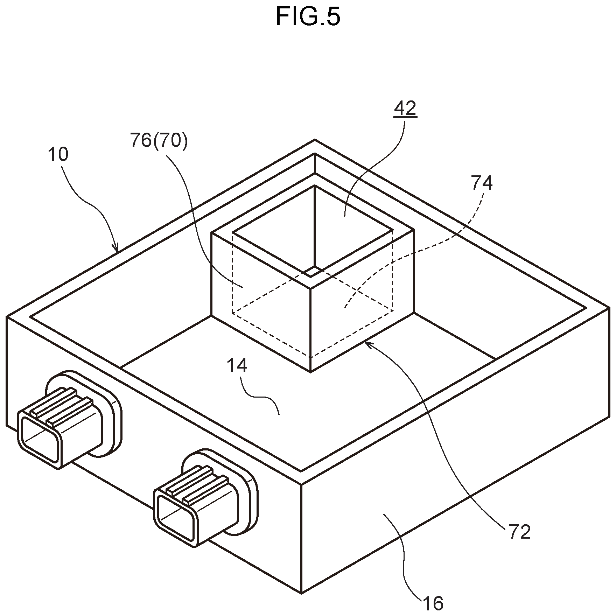

As illustrated in Fig. 5, the partition portion 40 according to the above exemplary embodiment may be a partition portion 70 configuring at least a portion of a module case 72 that forms an independent housing space inside the housing 10. In Fig. 5, for simplicity of explanation, illustration of electronic components housed inside the housing 10 is omitted. In the first modified example, the housing space inside the box-shaped module case 72 is the resin-sealed compartment 42. As an example, the module case 72 is formed in a rectangular box shape that is open upward, and includes a bottom wall portion 74 configuring a bottom face of the housing space inside the housing 10, and a side wall portion 76 that stands upright from a peripheral portion of the bottom wall portion 74. The partition portion 70 is configured by the side wall portion 76 of the module case 72.

According to the first modified example, the partition portion 70 configures at least a portion of the module case 72 forming an independent housing space inside the housing 10, and the housing space inside the module case 72 is the resin-sealed compartment 42. This enables electronic components that require resin sealing to be modularized and assembled into the housing 10 in the manufacturing process.

### (Second Modified Example)

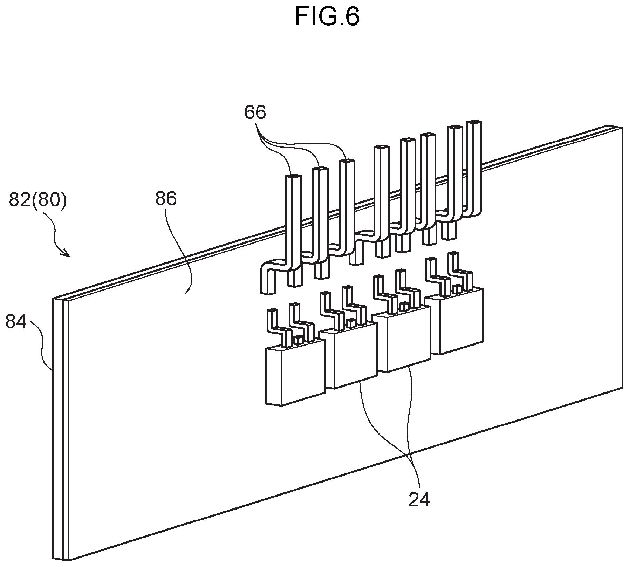

As illustrated in Fig. 6, the partition portion 40 according to the above exemplary embodiment may be configured with a heat dissipation substrate 82. The partition portion 80 according to the second modified example is configured by a heat dissipation substrate 82 in which wiring (not illustrated) is provided via an insulating layer 86 over a base substrate 84 made of a metal with high thermal conductivity. At least a portion of the PFC circuit portion 21 and the plural switching elements 24 included in the converter circuit portion 22 housed inside the housing 10 are mounted on the heat dissipation substrate 82. Further, at least a portion of the wiring configuring the PFC circuit portion 21 and the converter circuit portion 22 is formed on the heat dissipation substrate 82. Plural terminals 66 are connected to an upper end portion of the heat dissipation substrate 82. The plural terminals 66 extend toward the substrate housing portion 46 inside the housing 10, and are connected to the wiring board 30.

According to the second modified example, the partition portion 80 is a member that partitions the housing space inside the housing 10, and configures at least a portion of the wiring board. This enables the number of members to be reduced, thereby enabling cost reduction to be achieved.

### (Third Modified Example)

Further, although not illustrated in the drawings, the partition portion 40 according to the above exemplary embodiment may be configured by a printed wiring board in which wiring is formed using a conductor on a substrate formed of an insulating material such as resin or the like.

### (Fourth Modified Example)

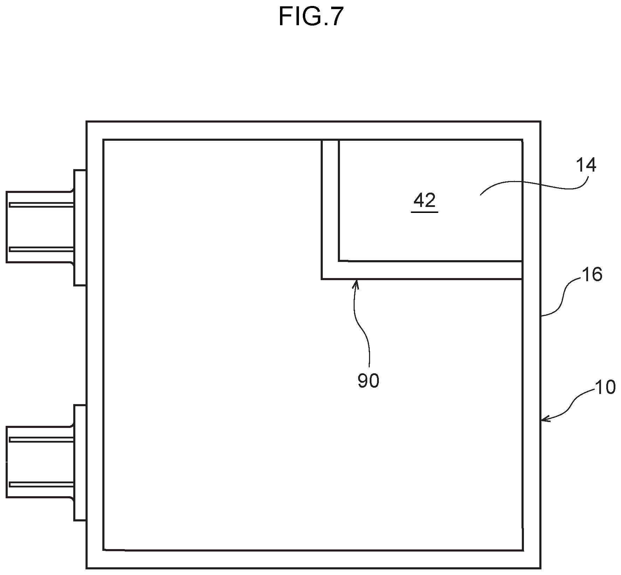

Further, while the partition portion 40 according to the above exemplary embodiment is formed in a rectangular plate shape, it is not limited thereto. The shape of the housing 10 can be appropriately changed in order to partially partition the housing space inside the housing 10. As illustrated in Fig. 7, for example, a partition portion 90 may be configured in a plate shape bent into an L shape. The partition portion 90 partitions the housing space inside the housing 10 with two sides configured by the side wall portions 16 of the housing 10, and the two sides of the partition portion 90. The housing space inside the partition portion 90 is the resin-sealed compartment 42.

Further, in the above exemplary embodiment and modified examples, the partition portions are configured separately from the housing 10; however, the present invention is not limited thereto. Configuration may be such that the partition portion is integrally formed with the housing 10, by configuring the housing 10 as a die-cast housing. In the above exemplary embodiment and modified examples, drawings without a lid are illustrated, but it is also possible to use a lid. Further, the lid and the case may be fixed by means of screws, adhesive, or the like.

Japanese Patent Application No. 2024-008923 filed on January 24, 2024, the disclosure of which is incorporated by reference herein.

## Claims

1. An electronic device, comprising:
a housing;
a partition portion partitioning a housing space inside the housing; and
an electronic component fixed to the partition portion and using the partition portion as a heat dissipation path,
wherein an interior of a partitioned compartment is resin-sealed.

2. The electronic device of claim 1, wherein the partition portion is separate from the housing.

3. The electronic device of claim 1 or claim 2, wherein the electronic component is fixed to a side of the partition portion on which resin sealing is performed.

4. The electronic device of claim 1 or claim 2, wherein:
the partition portion constitutes at least a part of a module case that forms an independent internal space within the housing, and
the internal space of the module case is the resin-sealed compartment.

5. The electronic device of claim 1 or claim 2, wherein:
the partition portion is configured as a heat dissipation substrate including wiring provided on a base substrate via an insulating layer, and
the electronic component is mounted on the heat dissipation substrate.

6. The electronic device of claim 1 or claim 2, wherein, within an interior space of the housing, the partition portion forms the resin-sealed compartment, a substrate housing portion corresponding to the partition portion is formed, and a connection member extending from the electronic component fixed to the partition portion is connected to a wiring board disposed in the substrate housing portion.
